# EUROPEAN PATENT APPLICATION

(11) **EP 4 261 615 A1**
(43) Date of publication of application: **18.10.2023**
(21) Application number: 21902911.3
(22) Date of filing: 14.04.2021
(51) Int. Cl.: G03F 7/20

(54) **EXPOSURE HEAD, CALIBRATION SYSTEM, AND DRAWING DEVICE**

(30) Priority: 08.12.2020 JP 2020203601
(71) Applicant: Inspec Inc., Senboku City Akita, 014-0341 (JP)
(72) Inventor: SUGAWARA, Masashi, Senboku City, Akita 0140341 (JP)
(74) Representative: Hasegawa, Kan
(86) International application number: PCT/JP2021/015516
(87) International publication number: WO 2022/123804

(57) **Abstract**

An exposure head, etc., in which the intensity of an exposure beam for scanning a substrate can be calibrated as needed without increasing the size of a drawing device. The exposure head is an exposure head for irradiating a substrate conveyed in a predetermined direction with an exposure beam while scanning the substrate with the exposure beam in a one-dimensional manner, including: a polygon mirror that has multiple reflecting surfaces and is provided in a rotatable manner; an optical element that is configured to cause the beam emitted from a light source and shaped into a beam shape to enter the polygon mirror; an imaging optical system that is configured to image the beam reflected by the polygon mirror onto an exposure surface of the substrate, a reflecting mirror that is provided insertably into or removably from the optical path of the beam entering the optical element, the reflecting mirror being configured to reflect the beam in a direction different from the optical path while being inserted into the optical path; and a light-receiving element that is arranged at a position where the beam reflected by the reflecting mirror can enter the light-receiving element, and that is capable detecting an intensity of the beam.

## Description

### TECHNICAL FIELD

The present invention relates to exposure heads that emit exposure beams, calibration systems, and drawing devices.

### BACKGROUND ART

In recent years, the amount of electronics used in transportation machines such as automobiles and aircraft has been steadily increasing. Along with this, the number of wire harnesses used for power supply and/or signal transmission and reception with respect to the electronics is also increasing. On the other hand, weight reduction and space saving are required in the transportation machines, and an increase in weight and space occupation due to the increase of the wire harnesses is therefore becoming a problem.

In view of these problems, investigations have been made to replace the wire harnesses used in transportation machines with long sheet-like flexible printed circuits (FPCs).

As a technique for patterning on a long sheet-like substrate, NPTL 1 discloses a technique of performing alignment measurement, overlay exposure, and workpiece replacement in parallel, in order to perform a process while continuously conveying the film a roll-to-roll method without stopping the film from being conveyed.

In addition, PTL1 discloses a system in which calibration can be performed as needed in a roll-to-roll-type drawing device.

### PRIOR ART DOCUMENTS

### PATENT LITERATURE

PTL1: WO2020/100446

### NON-PATENT LITERATURE

NPTL 1: Yoshiaki Kito, et al., "Direct Imaging Exposure Equipment with High Overlay Accuracy for Flexible Substrate in Roll-to-Roll Method," Journal of the Institute of Image Information and Television Engineers, Vol. 71, No. 10, pp. J230-J235 (2017), the Institute of Image Information and Television Engineers, September 8, 2017

### SUMMARY OF THE INVENTION

### PROBLEMS TO BE SOLVED BY THE INVENTION

In equipment requiring a high level of safety, such as automobiles and aircraft, traceability is required in order to ensure the high reliability of each component constituting the equipment. For this reason, regarding a patterned substrate, in the step of patterning the substrate, it is necessary to perform calibration on a regular basis for checking the intensity, and the like, of the exposure beam, and to save the calibration data.

In this respect, in PTL 1, calibration can be performed as needed even in the case of forming a continuous pattern on a long substrate without removing the substrate from the conveying drum. However, in PTL 1, even in the case of calibrating the beam intensity, the exposure head support part needs to be moved to create a space where the sensor unit can be arranged, and therefore, it can be considered that the drawing device may increase in size.

The present invention has been made in view of the above, and an object of the present invention is to provide an exposure head, a calibration system, and a drawing device, in which the intensity of an exposure beam for scanning a substrate can be calibrated as needed without increasing the size of the drawing device.

### MEANS FOR SOLVING THE PROBLEMS

To solve the above problems, the exposure head, which is one aspect of the present invention, is an exposure head for irradiating a substrate conveyed in a predetermined direction with an exposure beam while scanning the substrate with the exposure beam in a one-dimensional manner, comprising: a polygon mirror that has multiple reflecting surfaces and is provided in a rotatable manner; an optical element that is configured to cause the beam emitted from a light source and shaped into a beam shape to enter the polygon mirror; an imaging optical system that is configured to image the beam reflected by the polygon mirror onto an exposure surface of the substrate; a reflecting mirror that is provided insertably into or removably from an optical path of the beam entering the optical element, the reflecting mirror being configured to reflect the beam in a direction different from the optical path while being inserted into the optical path; and a light-receiving element that is arranged at a position where the beam reflected by the reflecting mirror can enter the light-receiving element, and that is capable of detecting an intensity of the beam.

The above-described exposure head may further comprise: a light source; and a beam-shaping optical system that is configured to shape light output from the light source into a beam shape.

The above-described exposure head may further comprise: a mirror support part that supports the reflecting mirror; and a rotary drive mechanism that is configured to insert or remove the reflecting mirror into or from the optical path by rotating the mirror support part.

In the above-described exposure head, the rotary drive mechanism may be configured to rotate the mirror support part in a plane parallel to a plane containing the optical path and a second optical path along which the beam reflected by the reflecting mirror is directed toward the light-receiving element.

The calibration system, which is another aspect of the present invention, is a calibration system for calibrating an intensity of an exposure beam that is emitted from an exposure head and irradiated onto a substrate conveyed in a predetermined direction while the exposure beam is scanned in a one-dimensional manner, the exposure head including: a polygon mirror that has multiple reflecting surfaces and is provided in a rotatable manner; an optical element that is configured to cause the beam emitted from a light source and shaped into a beam shape to enter the polygon mirror; and an imaging optical system that is configured to image the beam reflected by the polygon mirror onto an exposure surface of the substrate, comprising: a reflecting mirror that is provided insertably into or removably from an optical path of the beam entering the optical element, the reflecting mirror being configured to reflect the beam in a direction different from the optical path while being inserted into the optical path; a light-receiving element that is arranged at a position where the beam reflected by the reflecting mirror can enter the light-receiving element, and that is capable of detecting an intensity of the beam; a control part that is configured to generate data representing the intensity of the beam based on a detection signal output from the light-receiving element; and a storage part that is configured to store the data as calibration data.

The above-described calibration system may further comprise an inserting/removing mechanism that is configured to insert or remove the reflecting mirror into or from the optical path, and wherein the control part may further be configured to control operations of the inserting/removing mechanism.

In the above-described calibration system, the storage part may be configured to further store reference data representing a reference intensity of the beam, and wherein the control part may include a determination part that is configured to determine, based on the calibration data and the reference data, whether an intensity of a beam that has entered the light-receiving element falls within a predetermined range.

In the above-described calibration system, the control part may further include a correction part that is configured to generate correction data for correcting an output of the light source if the intensity of the beam that has entered the light-receiving element fails to fall within the predetermined range based on the determination result by the determination part.

The drawing device, which is another aspect of the present invention, comprises: a calibration system for calibrating an intensity of an exposure beam that is emitted from an exposure head and irradiated onto a substrate conveyed in a predetermined direction while the exposure beam is scanned in a one-dimensional manner; and conveying means that is configured to convey the substrate, wherein the exposure head includes: a polygon mirror that has multiple reflecting surfaces and is provided in a rotatable manner; an optical element that is configured to cause the beam emitted from a light source and shaped into a beam shape to enter the polygon mirror; and an imaging optical system that is configured to image the beam reflected by the polygon mirror onto an exposure surface of the substrate, wherein the calibration system includes: a reflecting mirror that is provided insertably into or removably from an optical path of the beam entering the optical element, the reflecting mirror being configured to reflect the beam in a direction different from the optical path while being inserted into the optical path; a light-receiving element that is arranged at a position where the beam reflected by the reflecting mirror can enter the light-receiving element, and that is capable of detecting an intensity of the beam; a control part that is configured to generate data representing the intensity of the beam based on a detection signal output from the light-receiving element; and a storage part that is configured to store the data as calibration data, and wherein the exposure head is arranged such that the beam is scanned in a direction orthogonal to the direction in which the substrate is conveyed.

In the above-described drawing device, a plurality of the exposure heads may be provided in parallel in a direction orthogonal to the direction in which the substrate is conveyed.

### EFFECT OF THE INVENTION

According to the present invention, the intensity of the exposure beam for scanning the substrate can be calibrated as needed without increasing the size of the drawing device because a reflecting mirror is provided, in the exposure head, insertably into or removably from an optical path to an optical element for causing the beam to enter the polygon mirror, and a light-receiving element is arranged at a position where the beam reflected by the reflecting mirror can enter the light-receiving element.

### BRIEF DESCRIPTION OF THE DRAWINGS

FIG. 1 is a schematic diagram showing a schematic configuration of a drawing device according to an embodiment of the present invention.
FIG. 2 is a plan view of the drawing device shown in FIG. 1.
FIG. 3A is a schematic diagram showing a schematic configuration of the inside of an exposure head.
FIG. 3B is a schematic diagram showing a schematic configuration of the inside of the exposure head.
FIG. 4 is a schematic diagram of the exposure head shown in FIG. 1 as seen from the substrate side.
FIG. 5 is a block diagram showing a schematic configuration of a controller shown in FIG. 1.
FIG. 6 is a flowchart illustrating operations at the time of calibration of the drawing device shown in FIG. 1.

### EMBODIMENTS OF THE INVENTION

Hereinafter, an exposure head, a calibration system, and a drawing device according to embodiments of the present invention will be described with reference to the drawings. It should be noted that the present invention is not limited by these embodiments. In the description of each drawing, the same parts are denoted by the same reference numbers.

The drawings referred to in the following description are merely schematic representations of shape, size, and positional relationship to the extent that the subject matter of the present invention may be understood. In other words, the present invention is not limited only to the shapes, sizes, and positional relationships illustrated in the respective figures. In addition, the drawings may also include, among themselves, parts having different dimensional relationships and ratios from each other.

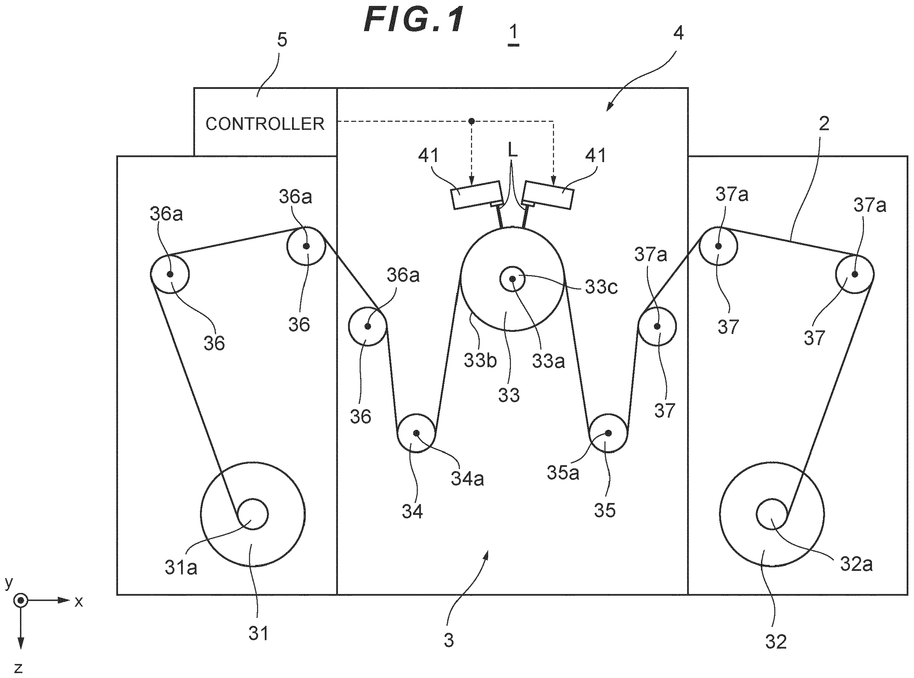

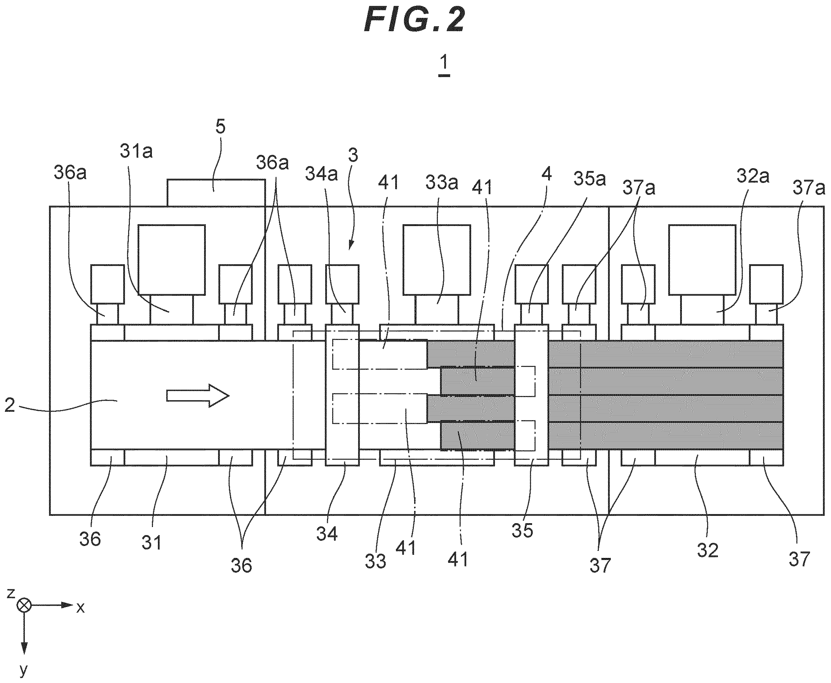

FIG. 1 is a schematic diagram showing a schematic configuration of a drawing device according to an embodiment of the present invention. FIG. 2 is a plan view of the drawing device. As shown in FIGS. 1 and 2, the drawing device 1 according to the present embodiment includes a conveying system 3 for conveying a long sheet-like substrate 2, a drawing unit 4 for forming a pattern by irradiating the substrate 2 with an exposure beam L, and a controller 5 for controlling the operation of the conveying system 3 and the drawing unit 4. In the following, the direction in which the substrate 2 is conveyed will be referred to as the x direction, the width direction of the substrate 2 will be referred to as the y direction, and the vertical direction will be referred to as the z direction (positive in the downward direction).

In the present embodiment, a flexible printed circuit (FPC) is used as the substrate 2 to be processed. The FPC is a flexible circuit substrate obtained by bonding a metal foil, such as copper, to a base film made of an insulating resin, such as polyimide. The substrate 2 is, for example, a strip-like FPC of several meters to several tens of meters in length, and the substrate is unwound from a state of being wound in a roll on an unwinding reel 31 and is wound on a take-up reel 32 after being patterned thereon by the drawing unit 4 while being conveyed by the conveying system 3. As seen from the above, this method of conveyance in which the strip-like workpiece is unwound from a roll and wound around a roll after application of predetermined processing is referred to as a "roll-to-roll" method.

In the conveying system 3, a rotary shaft 31a for rotatably supporting the unwinding reel 31, a rotary shaft 32a for rotatably supporting the take-up reel 32, a conveying drum 33, tension pulleys 34, 35 provided respectively on the upstream side (left side in FIG. 1) and the downstream side (right side in FIG. 1) of the conveying drum 33, and a plurality of guide rollers 36, 37 are provided.

The conveying drum 33 has a cylindrical shape as a whole and is supported by a rotary shaft 33a which rotates by the rotational driving force supplied from a drive source. The conveying drum 33 is conveying means configured to support the substrate 2 in a region of substantially the upper half of the outer periphery 33b thereof, and to convey the substrate 2 as the conveying drum itself rotates. Further, the conveying drum 33 is provided with an encoder 33c for measuring the amount of rotation of the conveying drum 33.

The two tension pulleys 34, 35 are respectively rotatably supported on rotary shafts 34a, 35a which are movable in the vertical direction, and are located below the conveying drum 33. A tension adjusting mechanism for biasing the rotary shaft 34a, 35a downward is coupled to each rotary shaft 34a, 35a. The substrate 2 wound over the conveying drum 33 can be conveyed with a predetermined tension applied thereon by biasing the tension pulleys 34, 35 downward via the rotary shafts 34a, 35a by means of the tension adjusting mechanism.

Each guide roller 36 is rotatably supported on a rotary shaft 36a and guides the substrate 2 unwound from the unwinding reel 31 to the upstream-side tension pulley 34. Each guide roller 37 is rotatably supported on a rotary shaft 37a and guides the substrate 2 that has been applied with pattern-forming processing from the downstream-side tension pulley 35 to the take-up reel 32.

The configuration of the roll-to-roll-type conveying system 3 is not limited to the configuration shown in FIGS. 1 and 2, as long as the substrate 2 is conveyed and the pattern-forming processing can be applied to the substrate 2 supported on the outer periphery 33b of the conveying drum 33. Further, a unit (a preprocessing unit, a post-processing unit, etc.) that performs different processing may be provided between unwinding of the substrate 2 from the unwinding reel 31 and reaching thereof to the conveying drum 33, or between removal of the substrate 2 from the conveying drum 33 and winding thereof on the take-up reel 32. It should be noted that an edge position control (EPC) device is typically provided in the conveying system 3, which detects the edge position of the substrate 2 and finely moves the unwinding device or the take-up device in order to prevent meandering during conveyance of the substrate.

In the drawing unit 4, multiple exposure heads 41 are provided for irradiating the substrate 2 with the exposure beams L while scanning the substrate 2 with the exposure beams L in a one-dimensional manner. These exposure heads 41 are arranged such that the beams L scan in the direction (the y direction) orthogonal to the direction in which the substrate 2 is conveyed, and they draw a pattern, such as a circuit or a wiring, on the substrate 2 by irradiating the substrate 2 with the beams L.

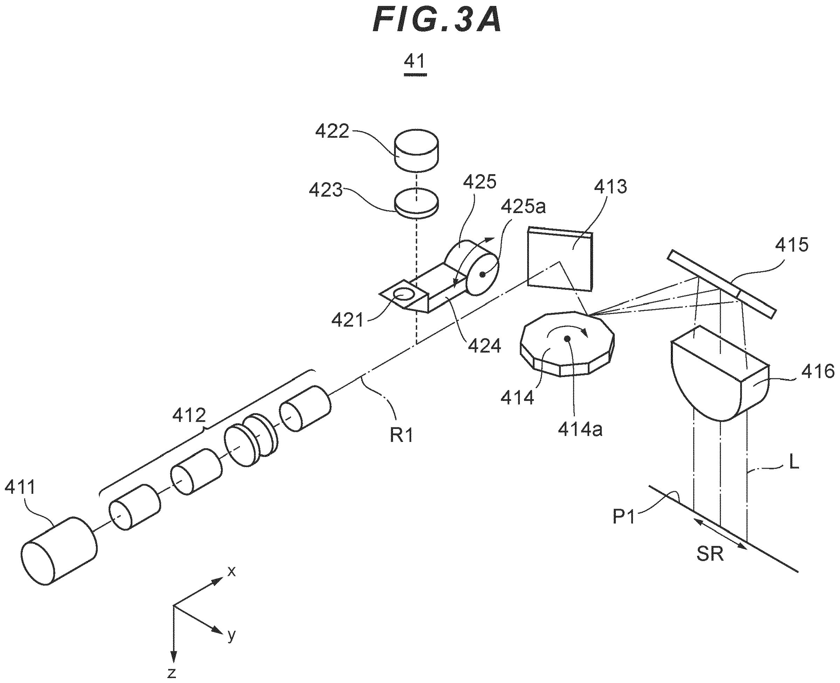

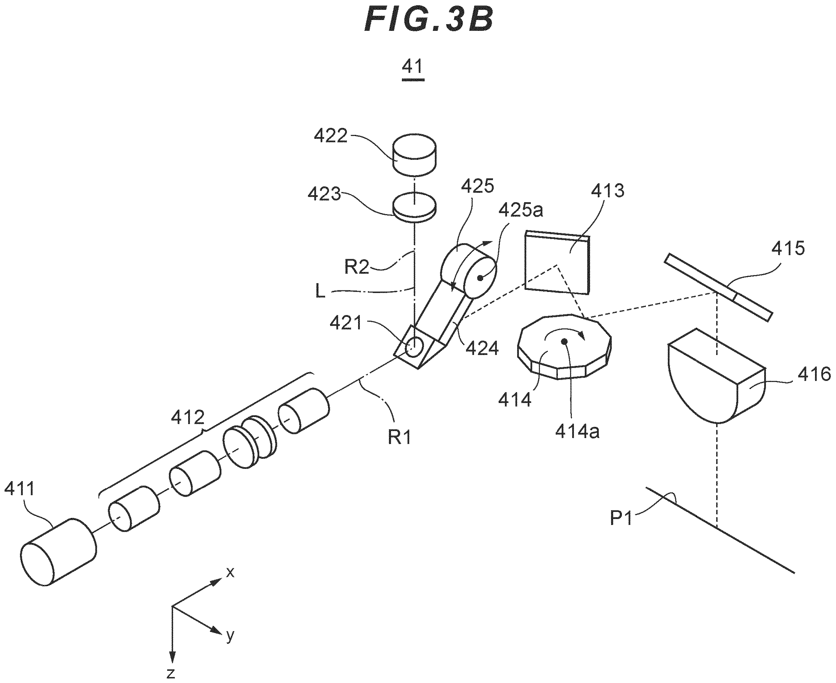

FIGS. 3A and 3B are schematic diagrams showing schematic configurations of the inside of the exposure head 41. Of these, FIG. 3A shows the state in which the drawing is performed on the substrate 2 by the beams L, and FIG. 3B shows the state in which calibration of the beams L is performed.

As shown in FIG. 3A, a light source 411 that outputs laser light, a beam-shaping optical system 412, a first reflecting mirror 413, a polygon mirror 414, a second reflecting mirror 415, an imaging optical system 416, a calibration mirror 421, and a light-receiving element 422 are provided inside the exposure head 41. In addition, an ND filter (neutral density filter) 423 may be arranged between the calibration mirror 421 and the light-receiving element 422.

The beam-shaping optical system 412 includes an optical element, such as a collimator lens, a cylindrical lens, a light amount adjusting filter, and a polarizing filter, and is configured to shape the laser light output from the light source 411 into a beam shape.

The first reflecting mirror 413 is an optical element configured to reflect the beam L emitted from the light source 411 and shaped by the beam-shaping optical system 412 into a beam shape to thereby cause the beam L to enter the polygon mirror 414.

The polygon mirror 414 is provided with a drive device that rotates the polygon mirror 414 around a rotary shaft 414a. While rotating around the rotary shaft 414a, the polygon mirror 414 causes the beam L to scan at a constant angular velocity by reflecting the beam L entering from the direction of the first reflecting mirror 413.

The second reflecting mirror 415 folds the beam L by reflecting the beam L reflected by the polygon mirror 414.

The imaging optical system 416 includes an optical element, such as an fθ lens or a telecentric fθ lens, and is configured to cause the beam L that is reflected by the polygon mirror 414 and that has passed by the second reflecting mirror 415 to be imaged on an exposure surface of the substrate 2. This allows the beam L to scan at a constant velocity along the one-dimensional scanning line P1 on the substrate 2.

The configuration of the exposure head 41 after the polygon mirror 414 is not limited to the one shown in FIG. 3A. For example, the second reflecting mirror 415 may be omitted, and the imaging optical system 416 may be installed with the incidence surface thereof facing the direction of the emitting surface of the beam L from the polygon mirror 414, and thereby the beam L reflected by the polygon mirror 414 may directly enter the imaging optical system 416. The orientation of the exposure head 41 installed in the drawing unit 4 may be set appropriately depending on the emitting direction and scanning direction of the beam L emitted from the imaging optical system 416.

The calibration mirror 421 is a reflecting mirror provided insertably into or removably from an optical path R1 of the beam L that is emitted from the beam-shaping optical system 412 and that enters the first reflecting mirror 413. As shown in FIG. 3B, the calibration mirror 421 is configured to reflect the beam L in a direction different from the optical path R1 while it is inserted into the optical path R1. In FIG. 3B, the calibration mirror 421 is inserted so that its reflecting surface is at 45 degrees relative to the optical path R1, and the beam L is reflected vertically upward (in the -z direction) of the optical path R1 (see the optical path R2).

In the present embodiment, the calibration mirror 421 is supported by a mirror support part 424. The mirror support part 424 is mounted to a rotary drive mechanism (e.g., a motor) 425 that rotates around a rotary shaft 425a. The calibration mirror 421 is inserted into or removed from the optical path R1 by rotating the mirror support part 424 by the rotary drive mechanism 425. In the present embodiment, the mirror support part 424 is rotated in a plane parallel to the plane containing the optical path R1 and the optical path R2.

The mechanism for inserting or removing the calibration mirror 421 into or from the optical path R1 is not limited to the rotary drive mechanism 425. For example, the calibration mirror 421 may be inserted into or removed from the optical path R1 by translational motion.

The light-receiving element 422 is arranged at a position where the beam L reflected by the calibration mirror 421 can enter the light-receiving element and it detects the intensity of the entered beam L and outputs a detection signal. A general position sensitive detector (PSD) or a light intensity detection element may be used as the light-receiving element 422.

The ND filter 423 protects the light-receiving element 422 by attenuating the light quantity of the beam L reflected by the calibration mirror 421.

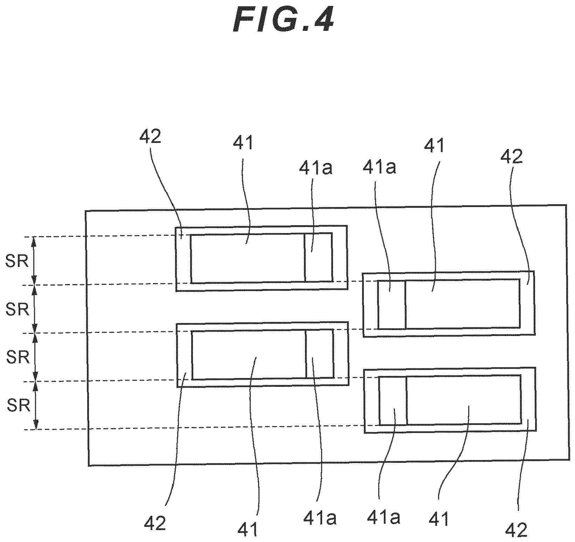

FIG. 4 is a plan view of the multiple exposure heads 41 provided in the drawing unit 4 as seen from the substrate 2 side. Although four exposure heads 41 are shown in FIG. 4, the number of exposure heads 41 is not limited to four. If is sufficient if the number of exposure heads 41 is one or more, and the number can be appropriately set depending on the width of the substrate 2, the scan range SR (see FIG. 3A) of the exposure head 41, the power of the beam L, and the like.

Each exposure head 41 is mounted to a support mechanism provided inside the drawing unit 4 via an adjustment stage 42. The adjustment stage 42 is provided for manually fine-adjusting the position of the exposure head 41 in the x and y directions as well as the angle with respect to the vertical direction. These exposure heads 41 are arranged such that the edges of the scan ranges SR of the beams L emitted from beam emitting ports 41a slightly overlap each other or are adjacent to each other without any space therebetween, between the beams L that scan the adjacent regions in the width direction (y direction) of the substrate 2. Thereby, scanning can be performed without any space in the width direction of the substrate 2 by means of the multiple beams L.

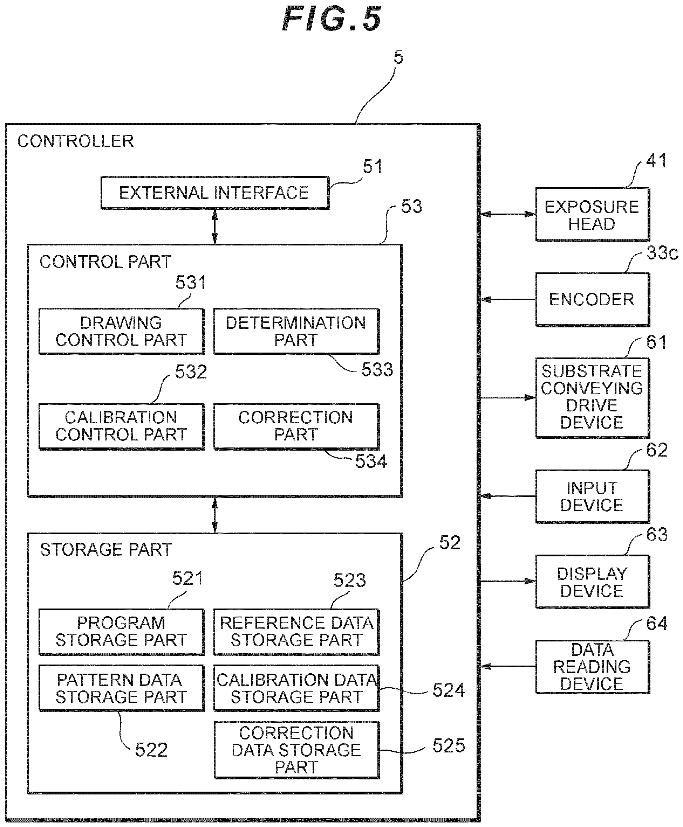

FIG. 5 is a block diagram showing a schematic configuration of the controller 5. The controller 5 is a device that comprehensively controls the operation of each component of the drawing device 1, and includes an external interface 51, a storage part 52, and a control part 53. The calibration system in the present embodiment includes this controller 5, the calibration mirror 421 in the exposure head 41, and the light-receiving element 422.

The external interface 51 is an interface for connecting various external devices to the controller 5. Examples of the external devices connectable to the controller 5 include the exposure head 41 (i.e., the light source 411, the light-receiving element 422, the rotary drive mechanism 425), the encoder 33c, a substrate conveying drive device 61 that drives the conveying system 3, an input device 62 such as a keyboard or a mouse, a display device 63 such as a liquid crystal monitor, and a data reading device 64 for loading pattern data or the like into the controller 5.

The storage part 52 is configured by using a computer readable storage medium such as a disk drive and/or a semiconductor memory (e.g. a ROM or RAM). The storage part 52 stores, in addition to an operating system program and a driver program, a program for causing the controller 5 to execute a predetermined operation, various types of data and setting information used during execution of the program, and the like.

Specifically, the storage part 52 includes a program storage part 521, a pattern data storage part 522, a reference data storage part 523, a calibration data storage part 524, and a correction data storage part 525. The program storage part 521 stores the various types of programs described above. The pattern data storage part 522 stores data representing patterns to be drawn by the drawing unit 4. The reference data storage part 523 stores reference data of the intensities of the beams L. Here, the reference data refers to data representing an intensity (hereinafter also referred to as a reference intensity) of a beam L at the light-receiving element 422 corresponding to a predetermined irradiation intensity of the beam L at the exposure surface of the substrate 2. The calibration data storage part 524 stores calibration data of the beam L, i.e., data representing the intensity of the beam L that has entered the light-receiving element 422. The correction data storage part 525 stores correction data for adjusting the output of the light source 411 based on the calibration data.

The control part 53 is configured by using hardware such as a central processing unit (CPU), and reads the programs stored in the program storage part 521 to perform data transfer and instruction to each component of the controller 5 and the drawing device 1, and comprehensively controls the operation of the drawing device 1 to execute the pattern forming processing on the substrate 2. Further, by reading the calibration program stored in the program storage part 521, the control part 53 performs calibration of the exposure head 41 on a regular basis, stores the calibration data, and adjusts the output of the light source 411 based on the calibration data.

Specifically, functional parts implemented by the control part 53 executing the above-described programs include a drawing control part 531, a calibration control part 532, a determination part 533, and a correction part 534.

The drawing control part 531 reads the pattern data from the pattern data storage part 522, generates control data such as the power and scanning of the beam L by each exposure head 41 and the conveying speed of the substrate 2 by the conveying system 3, and outputs the control data to the exposure head 41 and the substrate conveying drive device 61. Thereby, the substrate 2 is conveyed at a predetermined speed by the conveying system 3, and a predetermined exposure region of the substrate 2 is irradiated and scanned in the width direction with the beam L emitted from each exposure head 41. In this manner, a two-dimensional pattern is formed on the substrate 2.

The calibration control part 532 performs control for calibrating the intensity of the beam L. Specifically, in accordance with an instruction input from the input device 62, or at a pre-set timing, the calibration mirror 421 is inserted into or removed from the optical path R1 by operating the rotary drive mechanism 425 of the exposure head 41.

The determination part 533 generates data (calibration data) representing the measured value (calibration value) of the intensity of the beam L detected by the light-receiving element 422, and determines whether the calibration value falls within a predetermined range based on the calibration data and the reference data stored in the reference data storage part 523.

The correction part 534 generates correction data for correcting the intensity of the beam L if the calibration values fail to fall within the predetermined range, and controls the output of the light source 411 based on the correction data.

It should be noted that the controller 5 may be configured by a single piece of hardware or may be configured by combining multiple pieces of hardware.

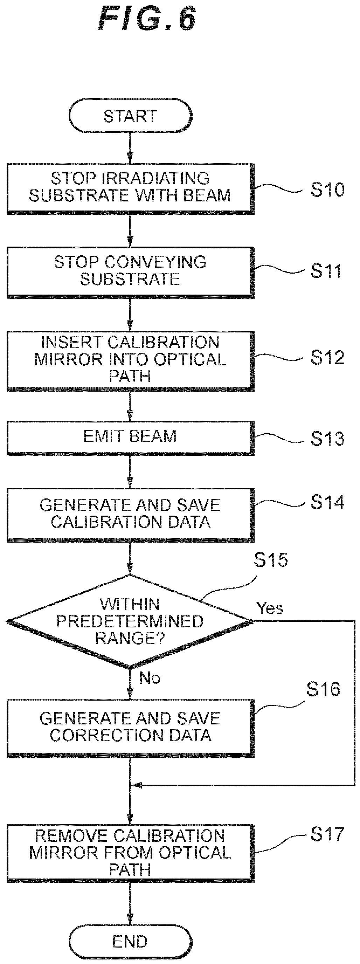

Next, a calibration method according to the present embodiment will be described. FIG. 6 is a flowchart illustrating the operation at the time of calibration of the drawing device 1.

First, in step S10, the controller 5 causes each exposure head 41 to stop irradiating the substrate 2 with the beam L.

In the subsequent step S11, the controller 5 causes the conveying system 3 to stop conveying the substrate 2.

In the subsequent step S12, the controller 5 inserts the calibration mirror 421 into the optical path R1 by rotating the rotary drive mechanism 425 of each exposure head 41 (see FIG. 3B).

In the subsequent step S13, the controller 5 causes the light source 411 to emit the beam L. The beam L emitted from the light source 411 and shaped into a beam shape is reflected by the calibration mirror 421 and enters the light-receiving element 422 via the ND filter 423. This allows the light-receiving element 422 to output a detection signal representing the intensity of the beam L.

In the subsequent step S14, the determination part 533 of the controller 5 generates, based on the detection signal output from the light-receiving element 422, data (calibration data) representing the measured value of the intensity of the beam L, and saves such data in the calibration data storage part 524.

In the subsequent step S15, the determination part 533 compares the calibration data generated in step S14 with the reference data stored in the reference data storage part 523 in order to determine whether the intensity of the beam L is within the predetermined range. Specifically, the determination part 533 calculates the difference of the measured value of the intensity of the beam L with respect to the reference intensity, and determines whether this difference is equal to or less than a predetermined threshold.

If the intensity of the beam L falls within the predetermined range (step S15: Yes), the operation proceeds to step S17.

On the other hand, if the intensity of the beam L falls outside the predetermined range (step S15: No), the correction part 534 generates correction data for correcting the output of the light source 411 and saves such data in the correction data storage part 525 (step S16). Specifically, the correction part 534 corrects output parameters of the light source 411. At this time, the correction part 534 may display the correction data on the display device 63.

In the subsequent step S17, the controller 5 removes the calibration mirror 421 from the optical path R1 by rotating the rotary drive mechanism 425 of each exposure head 41 (see FIG. 3A). Thereby, the operation for calibrating the intensity of the beam L in the drawing device 1 terminates. When the drawing operation resumes after termination of the calibration, each component operates based on the parameters corrected in step S16, and the drawing with respect to the substrate 2 can be performed by the beam L having the intensity corrected.

As explained above, according to the present embodiment, the intensity of the beam L emitted from each exposure head 41 can be calibrated as needed without increasing the size of the drawing device 1 because the calibration mirror 421 and the light-receiving element 422 are provided in each exposure head 41.

In addition, according to the present embodiment, the respective members used at the time of calibration (the calibration mirror 421 to the rotary drive mechanism 425) can be arranged in a compact manner in the exposure head 41 because the mirror support part 424 is rotated in a plane parallel to the plane containing the optical path R1 and the optical path R2. Therefore, the increase in size of the exposure head 41 can also be suppressed.

Now, in the above-described embodiment, the determination is made as to whether the measured value acquired in the calibration falls within the predetermined range, and processing for correcting the intensity of the beam L is performed if the measured value fails to fall within the predetermined range. However, it may be sufficient to perform calibration and simply save the calibration data, or simply save the correction data that is based on the calibration data.

The present invention as thus far described is not limited to the above-described embodiment, and various inventions can be formed by appropriately combining multiple components disclosed in the above-described embodiment. For example, such various inventions may be formed by excluding some components from all of the components shown in the above-described embodiment. By way of example, the above-described calibration mechanism may be applied to a drawing device where the light source is provided outside the exposure head, and the beam emitted from the light source is branched and directed to multiple exposure heads.

### DESCRIPTION OF REFERENCE NUMBERS

1... drawing device; 2... substrate; 3... conveying system; 4... drawing unit; 5...controller; 31, 32... reels; 31a, 32a, 33a, 34a, 35a, 36a, 37a, 415a, 425a... rotary shafts; 33... conveying drum; 33c... encoder; 33b... outer periphery; 34, 35... tension pulleys; 36, 37... guide rollers; 41... exposure head; 41a... beam emitting port; 42... adjustment stage; 51... external interface; 52... storage part; 53... control part; 61... substrate conveying drive device; 62... input device; 63... display device; 64... data reading device; 411... light source; 412... beam-shaping optical system; 413... first reflecting mirror; 414... polygon mirror; 415... second reflecting mirror; 416... imaging optical systems; 421... calibration mirror; 422... light-receiving element; 423... ND filter; 424... mirror support part; 425... rotary drive mechanism; 521... program storage part; 522... pattern data storage part; 523... reference data storage part; 524... calibration data storage part; 525... correction data storage part; 531... drawing control part; 532... calibration control part; 533... determination part; 534... correction part

## Claims

1. An exposure head for irradiating a substrate conveyed in a predetermined direction with an exposure beam while scanning the substrate with the exposure beam in a one-dimensional manner, comprising:
a polygon mirror that has multiple reflecting surfaces and is provided in a rotatable manner;
an optical element that is configured to cause the beam emitted from the light source and shaped into a beam shape to enter the polygon mirror;
an imaging optical system that is configured to image the beam reflected by the polygon mirror onto an exposure surface of the substrate;
a reflecting mirror that is provided insertably into or removably from an optical path of the beam entering the optical element, the reflecting mirror being configured to reflect the beam in a direction different from the optical path while being inserted into the optical path; and
a light-receiving element that is arranged at a position where the beam reflected by the reflecting mirror can enter the light-receiving element, and that is capable detecting an intensity of the beam.

2. The exposure head according to claim 1, further comprising:
a light source; and
a beam-shaping optical system that is configured to shape light output from the light source into a beam shape.

3. The exposure head according to claim 1 or 2, further comprising:
a mirror support part that supports the reflecting mirror; and
a rotary drive mechanism that is configured to insert or remove the reflecting mirror into or from the optical path by rotating the mirror support part.

4. The exposure head according to claim 3, wherein the rotary drive mechanism is configured to rotate the mirror support part in a plane parallel to a plane containing the optical path and a second optical path along which the beam reflected by the reflecting mirror is directed toward the light-receiving element.

5. A calibration system for calibrating an intensity of an exposure beam that is emitted from an exposure head and irradiated onto a substrate conveyed in a predetermined direction while the exposure beam is scanned in a one-dimensional manner, the exposure head including: a polygon mirror that has multiple reflecting surfaces and is provided in a rotatable manner; an optical element that is configured to cause the beam emitted from a light source and shaped into a beam shape to enter the polygon mirror; and an imaging optical system that is configured to image the beam reflected by the polygon mirror onto an exposure surface of the substrate, comprising:
a reflecting mirror that is provided insertably into or removably from an optical path of the beam entering the optical element, the reflecting mirror being configured to reflect the beam in a direction different from the optical path while being inserted into the optical path;
a light-receiving element that is arranged at a position where the beam reflected by the reflecting mirror can enter the light-receiving element, and that is capable detecting an intensity of the beam;
a control part that is configured to generate data representing the intensity of the beam based on a detection signal output from the light-receiving element; and
a storage part that is configured to store the data as calibration data.

6. The calibration system according to claim 5, further comprising:
an inserting/removing mechanism that is configured to insert or remove the reflecting mirror into or from the optical path,
wherein the control part is further configured to control operations of the inserting/removing mechanism.

7. The calibration system according to claim 5 or 6, wherein the storage part is configured to further store reference data representing a reference intensity of the beam, and
wherein the control part includes a determination part that is configured to determine, based on the calibration data and the reference data, whether an intensity of a beam that has entered the light-receiving element falls within a predetermined range.

8. The calibration system according to claim 7, wherein the control part further includes a correction part that is configured to generate correction data for correcting an output of the light source if the intensity of the beam that has entered the light-receiving element fails to fall within the predetermined range based on the determination result by the determination part.

9. A drawing device, comprising:
a calibration system for calibrating an intensity of an exposure beam that is emitted from an exposure head and irradiated onto a substrate conveyed in a predetermined direction while the exposure beam is scanned in a one-dimensional manner; and
conveying means that is configured to convey the substrate,
wherein the exposure head includes: a polygon mirror that has multiple reflecting surfaces and is provided in a rotatable manner; an optical element that is configured to cause the beam emitted from a light source and shaped into a beam shape to enter the polygon mirror; and an imaging optical system that is configured to image the beam reflected by the polygon mirror onto an exposure surface of the substrate,
wherein the calibration system includes:
a reflecting mirror that is provided insertably into or removably from an optical path of the beam entering the optical element, the reflecting mirror being configured to reflect the beam in a direction different from the optical path while being inserted into the optical path;
a light-receiving element that is arranged at a position where the beam reflected by the reflecting mirror can enter the light-receiving element, and that is capable of detecting an intensity of the beam;
a control part that is configured to generate data representing the intensity of the beam based on a detection signal output from the light-receiving element; and
a storage part that is configured to store the data as calibration data, and
wherein the exposure head is arranged such that the beam is scanned in a direction orthogonal to the direction in which the substrate is conveyed.

10. The drawing device according to claim 9, wherein a plurality of the exposure heads are provided in parallel in a direction orthogonal to the direction in which the substrate is conveyed.
